# EUROPEAN PATENT SPECIFICATION

(11) **EP 4 049 308 B1**
(45) Date of publication and mention of the grant of the patent: **20.05.2026**
(21) Application number: 20811715.0
(22) Date of filing: 22.10.2020
(51) Int. Cl.: H01L 21/67, H01L 21/677

(54) **METHOD AND APPARATUS FOR INTRODUCING A SUBSTRATE INTO A NIP**
VERFAHREN UND VORRICHTUNG ZUM EINBRINGEN EINES SUBSTRATS IN EINEN WALZENSPALT
PROCÉDÉ ET APPAREIL D'INTRODUCTION D'UN SUBSTRAT DANS UNE ZONE DE PINCEMENT

(30) Priority: 22.10.2019 GB 201915299
(43) Date of publication of application: 31.08.2022
(73) Proprietor: Lumet Technologies Ltd., 7612301 Rehovot (IL)
(72) Inventor: LANDA, Benzion, 7405135 Nes Ziona (IL); SHACHAK, Yosef, 4420942 Kfar Saba (IL); SANDERS, Jitschak, 5442111 Givat Shmuel (IL); NEGER, Ofir, 7528647 Rishon LeZion (IL)
(74) Representative: Harrison IP Limited
(86) International application number: PCT/IB2020/059931
(87) International publication number: WO 2021/079309

(56) References cited:
- WO-A1-97/29985
- AU-A1- 2019 200 607
- US-A1- 2011 209 749

## Description

### RELATED APPLICATION

This application claims Paris Convention priority from GB patent application No. 1915299.0 filed on October 22, 2019.

### FIELD

The present disclosure relates to application of a substance pattern to a substrate by transfer from a flexible web.

### BACKGROUND

In the manufacture of certain products, there arises a need to apply a substance pattern to a surface of a substrate. For example, in the manufacture of solar cells, circuit boards, touch screens and radio frequency identification (RFID) antennas, amongst other items, one may wish to apply to a substrate a substance that comprises a composition containing particles of an electrically conductive material, and typically a binder maintaining the particles in a desired shape (*e.g.,* pattern of lines, cross-section of lines, *etc*.) and/or an adhesive which may enhance adherence to the intended substrate or facilitate any functional interaction therewith. The substrate may, for instance, be a semiconductor wafer in the case of a solar cell, or it may be an electrically insulating substrate in the case of a printed circuit board. While such substrates are typically rigid and planar, flexible and/or non-flat (*e.g*., curved) substrates may also be used. In some cases, for example for an RFID device, it may be desired to apply a substance pattern directly onto a three-dimensional item, such as part of the body of a piece of equipment, whereupon the surface may be flat or curved.

Various methods are known for applying a substance pattern to a substrate. Generally, the substance pattern is formed directly on the substrate. In some methods, where a pattern of a substance is not intended to cover the entire surface, selective deposition of a substance may be performed to achieve a desired pattern, for instance by screen-printing. In other methods, the entire surface of the substrate may be coated with the substance, then part of the substance may be selectively removed, such as by etching or laser ablation, to leave the desired pattern. Each of these approaches has its own advantages and disadvantages.

The present Applicant has previously proposed, in WO 2018/020479 and WO 2018/020481, forming the substance pattern on the substrate by first filling grooves formed in a flexible web with the substance and subsequently transferring the pattern from the flexible web to the substrate. WO 2018/020483, discloses an apparatus for transferring a pattern of a composition containing particles of an electrically conductive material and a thermally activated adhesive from a surface of a flexible web to a surface of a substrate, the apparatus comprising:
i. respective drive mechanisms for advancing the web and the substrate at the same time through a nip at which a pressure roller acts to press the surfaces of the web and the substrate against one another,
ii. a heating station for heating at least one of the web and the substrate prior to, or during, passage through the nip, to a temperature at which the adhesive in the composition is activated when the surfaces are in contact with one another,
iii. a cooling station for cooling the web and the substrate after passage through the nip, and
iv. a separating device for peeling the web away from the substrate after passage through the cooling station to leave the pattern of composition adhered to the surface of the substrate.

When the above apparatus is used to print a pattern by transfer at speed on fragile (*e.g.,* thin and brittle) substrates, such as semiconductor wafers, the substrates risk being damaged or broken at the time of their being fed into the nip.

The following document is mentioned as being a pertinent prior art illustration:

AU 2019 200 607 A1 discloses an apparatus configured to apply a conductive pattern on a substrate.

The following documents are also mentioned as complementary prior art illustration:
US 2011/209749 A1;
WO 97/29985 A1.

### SUMMARY

With a view to mitigating the foregoing problem, there is provided, in accordance with a first aspect of the present disclosure, a system for transferring a substance pattern to a substrate, the system comprising a web carrying the substance pattern, a web drive mechanism for driving the web through a nip between a roller and an opposing surface, and a transport conveyor for advancing a substrate towards the nip for the substrate to be gripped in the nip and frictionally driven through the nip at the same time, and with the same speed, as the web, the web being pressed against a surface of the substrate during passage through the nip to cause the substance pattern to transfer from the web to the substrate, characterised in that at least one projection is provided on the transport conveyor to engage a trailing edge of the substrate and the transport conveyor is driven to advance the substrate towards the nip with a speed lower than that of the web, whereby the trailing edge of the substrate automatically disengages from the projection upon engagement of the leading edge of the substrate within the nip, thereby avoiding compression of the substrate. In some embodiments of the system, the transport conveyor does not apply to the substrate a force in a direction to advance the substrate towards the nip, the compression avoided being a lengthways compression of the substrate between the nip and the transport conveyor.

A feed conveyor can be provided to place substrates individually into a volume swept by the projections of the transport conveyor so that the trailing edge of the substrate can be engaged by a projection of the transport conveyor and thereby loaded onto the transport conveyor.

The purpose of the nip in the present invention is to apply a force urging the web and the substrate against one another to ensure transfer of the substance patterns from the web to the substrates. The substrate is gripped in the nip in absence of forces being applied by the transport conveyor, thereby avoiding compression of the substrate between the nip and the transport conveyor. Each side of the nip may either be a roller (*e.g.,* a pressure roller) or a low friction surface (*e.g*., opposing surface) relative to which the substrates or the web can slide easily. In embodiments of the invention described herein, at least the side of the nip in contact with the web is constituted by a roller.

If substance patterns are to be transferred to both sides of a substrate from two different webs, both transfers may either take place at the same time while the two web and the substrate pass through the same nip, or they may take place consecutively through two separate nips. In the former case, the nip can be constituted by two rollers facing one another, the two rollers being in one embodiment additionally symmetrical in size.

In accordance with a second aspect of the invention, there is provided a method of introducing a substrate into a nip defined between a pressure roller and an opposing surface through which the substrate is driven, in which method the substrate is advanced towards the nip by means of a transport conveyor that is configured to cease applying a force to the substrate upon engagement of the leading edge of the substrate within the nip, so as to avoid the substrate being compressed, characterised in that the transport conveyor is formed with a projection to engage a trailing edge of the substrate to push the substrate towards the nip, and the speed of the transport conveyor is set to less than the speed passage of the substrate through the nip, such that on entry of the leading edge of the substrate into the nip the trailing edge separates from the projection of the transport conveyor.

These and additional benefits and features of the disclosure, which are *inter alia* set forth in the appended claims, will be better understood with reference to the following detailed description taken in conjunction with the figures.

### BRIEF DESCRIPTION OF THE DRAWINGS

Some embodiments of the disclosure will now be described further, by way of example, with reference to the accompanying figures, where like reference numerals or characters indicate corresponding or like objects. The description, together with the figures, makes apparent to a person having ordinary skill in the art how some embodiments of the disclosure may be practiced. The figures are for the purpose of illustrative discussion and no attempt is made to show structural details of an embodiment in more detail than is necessary for a fundamental understanding of the disclosure. For the sake of clarity and convenience of presentation, some objects depicted in the figures are not necessarily shown to scale.

In the Figures:
Figure 1 illustrates a transferring system, as described in WO 2018/020483, for applying (*e.g*., electrically conductive) patterns to opposite sides of a substrate which can be modified according to the present teachings, in particular to include a novel apparatus for delivering a substrate;
Figure 2 shows a perspective view of a feeding mechanism for delivering a substrate to a nip at a correct time and speed in accordance with an embodiment of the present disclosure;
Figure 3 is a perspective section view of the apparatus shown in Figure 2;
Figure 4 is a perspective section view of the apparatus of Figure 2, the section taken being in a perpendicular plane to that of Figure 3;
Figure 5A and 5B schematically depict nips to which a substrate feeding mechanism according to the present disclosure may deliver substrates for the application of a substance pattern on one or more of its sides; and
Figure 6 schematically depict how pressure rollers and backing surfaces may be further coated and combined according to various embodiments of the present disclosure so as to form nips that may be implemented with a substrate feeding mechanism, such as illustrated *inter alia* in Figures 5A and 5B.

### DETAILED DESCRIPTION

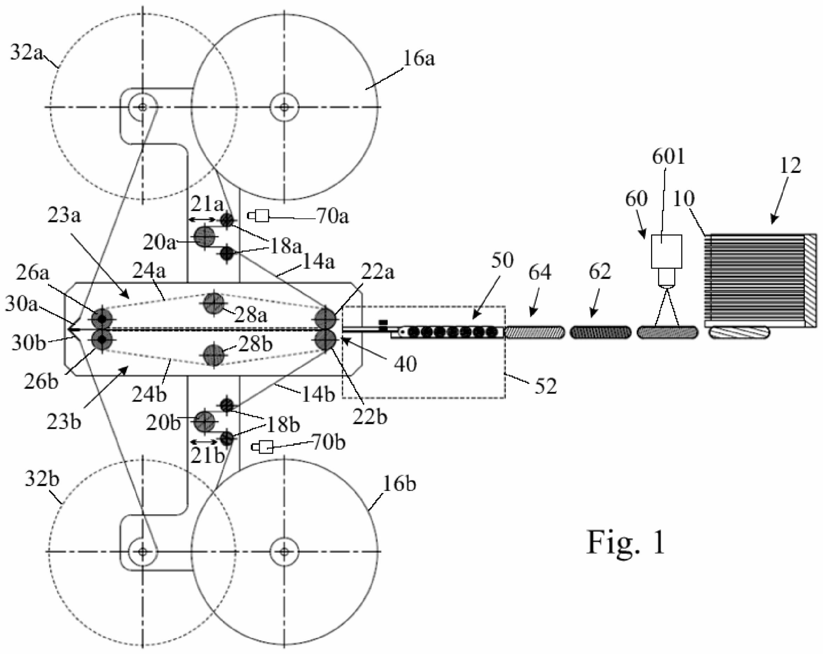

The apparatus of **Figure 1****,** as described in more details in WO 2018/020483, is intended to apply a substance pattern to opposite sides of substrates **10,** *e.g*., drawn from a stack **12** or from a cassette. For example, the substance of the pattern may be a composition that contains particles such as electrically conducting particles (*e.g*., made of metals or suitable alloys) and a thermally and/or pressure activated adhesive (*e.g*., a hot melt polyamide adhesive). Such patterns can be rendered electrically conductive, for example by application of energy to sinter the composition. The composition may not require the application of energy to become conductive, and in some cases electrical conductivity may not be required, the pattern, for example, only being ornamental. If the pattern is to be treated to develop its desired functional and/or esthetical effect, for instance is to be heated to become electrically conductive, or to be fused or cured to increase adhesion to the substrate, this treatment is typically performed following transfer of the pattern from the web to the substrate.

Thus, in one example considering a functional pattern able to conduct electricity, the substrates **10** may be semiconductor wafers onto which the apparatus applies the front and back electrodes of the desired end-product, which may be a solar cell. The transferred patterns may constitute at least part of the patterns desired on the substrate, for example they may form a grid-like pattern of fingers of a solar cell, transversal bus bars optionally being separately applied by a similar or different method. The two conductive patterns applied on opposite sides commonly differ from one another but may need to be each correctly aligned with the substrate (hence also with one another on each side of the substrate). In another example, the end-item may exclude a semiconductor wafer (*e.g*., may be an electrically insulating substrate, plastic, glass, *etc*.), may have functionality other than of a solar cell (*e.g.,* functionality of a circuit board, an RFID antenna, a display, a touch screen, *etc*.), and/or may be purely decorative.

In the non-limiting example of substrate drive mechanism illustrated in Figure 1, substrates **10** are dispensed one at a time from a stack **12** to an inspection station **60** where the upper surfaces of the substrates can be analysed optically for defects by a camera **601.** In a selection station **62** that follows, substrates found to be defective can be ejected.

Substrates **10** (preferably pre-inspected to be without defects) are advanced by a conveyor and alignment device **50** where they can be heated by a heater **52.** Optionally an adhesive adapted to improve the transfer of the pattern from the web and/or its retention on the substrate may be applied to the surface of the substrates or to parts thereof. After being heated, if desired, and correctly positioned and oriented, the substrates **10,** which may optionally be coated at least in part with an adhesive, are fed into a nip **40** defined between two pressure rollers **22** (**22a and 22b**), which may be identical and symmetrical, as illustrated in Figure 1.

While the inclusion of an inspection station **60** and a selection station **62** to detect and eject defective substrates is recommended, such stations are not essential for the operation of the apparatus, being only preferable from a quality control standpoint. Stations fulfilling similar roles downstream of the nip, *e.g*., following the peeling of the flexible web, can optionally be additionally or alternatively included to detect defective patterns and eject substrates bearing such defects, and/or to sort into various bins in accordance with quality level.

In the event that the apparatus does comprise stations **60** and **62** upstream of the nip, it can be desired to further include an accelerating station **64** allowing a non-defective substrate being drawn after a defective one, which was therefore ejected, to reach the nip in synchronism with the pattern(s) of the web(s). Such accelerating station **64** may therefore prevent an "empty" feeding of the web at the nip, in absence of a substrate. Such an accelerating station is, however, not essential as such empty feeding can be tolerated or mitigated by alternative means, such as adding a substrate pre-selected as flawless from a buffer of such non-defective wafers, or by any like solution.

Similar inspection stations may be placed at additional positions in the apparatus and configured to send relevant instructions to the system in response to the situations they are aimed to detect and signal. For instance, in case of substrate misfeeding, which can be detected by a sensor positioned upstream to the nip, the inspection station may cause the interruption of substrate feeding, the deceleration of web feeding and the cessation of operation of the apparatus (at least for the duration of the removal of the misfed substrate).

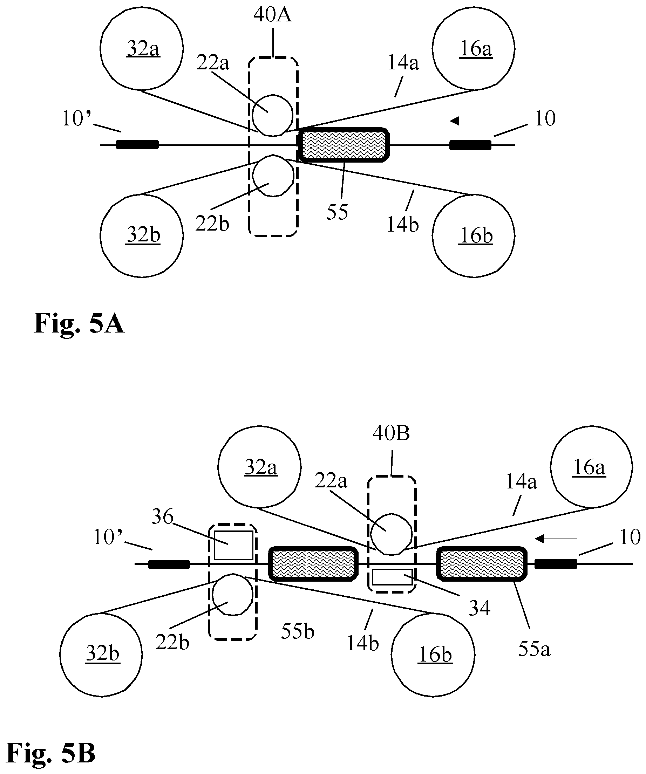

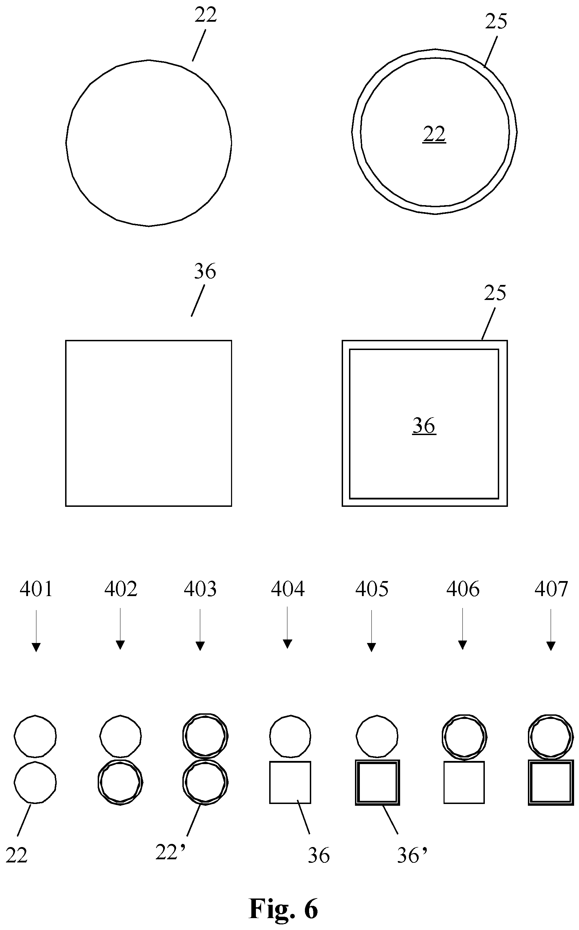

The patterns of substance that include the desired composition that are to be transferred to the substrates are carried by two flexible webs 14 (14a and 14b), which as mentioned need not be the same. As can clearly be seen from Figure 1, the drive mechanisms of the two webs **14** (**14a** and **14b**) can be mirror images of one another, but this need not be the case and alternative configurations are possible, as illustrated in, and described below by reference to Figures 5 and 6. To avoid repetition, reference numerals without a suffix will be used in the present description to refer generically to components of both web drive mechanisms but suffixes "a" and "b" are used in the drawings to distinguish between the upper and lower drive mechanisms.

Each web **14** (**14a or 14b**) is drawn from a supply roll **16,** for instance, by way of idler rollers **18** (**18a and 18b**) and a dancer **20** that can move from left to right as represented by an arrow **21.** The dancer **20** can serve to tension the web and also to ensure correct registration of the patterns on the web with the substrates **10.** When two webs are employed to apply substance patterns on opposite sides of the substrate, the tension rollers that may be present along each of their respective path can serve to achieve registration between the patterns carried by both webs.

Typically, when the web **14** (**14a or 14b**) is drawn from supply roll **16** (**16a or 16b**) the composition is level with the surface of the web and generally, but not necessarily, essentially dry. Optionally, an adhesive adapted to improve the transfer of the pattern from the web and/or its retention on the substrate may be applied to the web **14** (**14a or 14b**) subsequent to the drawing of the web **14** (**14a or 14b**) from supply roll **16** (**16a or 16b**) and prior to its contacting the substrate (*e.g*., upstream of the nip). The web **14** (**14a or 14b**) passes between the two pressure rollers **22** (**22a and 22b**) that define the nip **40** into which substrates **10** are fed.

Within the nip **40,** the substance / composition pattern on the web **14** (**14a or 14b**) is pressed against a surface of the substrate **10** resulting in the pattern of substance / composition adhering to the substrate.

The web **14** (**14a or 14b**) may then pass through an optional cooling station **23,** between two rollers **26** (**26a and 26b**) and be separated from the substrate **10,** *e.g.,* by a separating device **30** or by forming a take-up angle suitable for separation. After separation from the substrate **10** for instance by the device **30,** the web can be rewound on a take-up roll **32** (**32a or 32b**). If desired, the take-up **32** (**32a or 32b**) roll can be returned to the web supplier for recycling.

In the event that the take-up roll **32** (**32a or 32b**) is discarded, the web **14** (**14a or 14b**) may be referred to as a disposable web or flexible membrane. The process employing the webs as herein disclosed may be referred to as a "roll to roll" method, the webs from which patterns are transferred to the substrates being drawn from supply roll **16** (**16a or 16b**) and rewound on take-up roll **32** (**32a or 32b**).

If peeling is not desired, for example, because web **14** (**14a or 14b**) may additionally serve to protect substrate **10,** separating device **30** and take-up roll **32** (**32a or 32b**) may be omitted from the apparatus. The term "transferred" as used herein for a pattern of composition and variants thereof should be understood to also cover embodiments where the web and the substrate are not separated from one another. If cooling is not desired, for example, because the substance pattern is transferred by pressure and/or the transfer is not performed at an elevated temperature and/or the web need not be rapidly separated from the substrate, cooling station **23** may be omitted from the apparatus or turned off.

For the purpose of ensuring correct registration of the patterns of substance / composition with the substrates **10,** optical sensors **70** may be provided to sense the location of the patterns on the web **14** (**14a or 14b**), *e.g*., upstream of the idler rollers **18** (**18a and 18b**).

The type of sensors, their positioning along the paths followed by each of the webs and the substrate, the signals they may provide to a system adapted to control and take responsive actions and the responses they may trigger to different parts of the apparatus in order to ensure correct registration or to reduce erroneous registration within tolerance are known to the skilled persons and need not be detailed herein.

By way of non-limiting example, a controller may set a first speed to a web and adjust a second speed of the substrates while on the transportation conveyor, upon (and prior to) engagement of the substrate into the nip. The circumferential speed of the at least one pressure roller of the nip is essentially the same as the linear speed of the web, so that when comparing the speed of the substrate to the speed of the nip, reference is made to the corresponding linear speed of each. The Applicant avoids lengthways compression of the substrates *inter alia* by ensuring that the nip has a speed greater than the speed of the substrate upon engagement therewith. This can be achieved either by increasing the speed of the web with respect to the substrate, or by reducing the speed of the substrate with respect to the web.

While the figures schematically illustrate an apparatus allowing simultaneous transfer of two patterns onto respective opposite surface of the substrate, the skilled person can readily appreciate how a similar apparatus can be prepared to transfer patterns of substance / composition on a single substrate side or on a single substrate side at a time (*e.g*., two nips being required to sequentially apply a pattern from a first web to a first side and a pattern of a second web on a second side). In such a case, nip **40,** whether sole, first or second nip of the apparatus, for instance, can be formed between a single pressure roller **22** (**22a**) and a backing support **34** for substrate **10.** The backing support may be static (*e.g.,* a plate, the pressure roller and/or the movement of the web driving the displacement of the substrate thereupon) or may be in motion (*e.g.,* a conveyor adapted to transport the substrate at a speed selected to match the relative movement of the respective web). As a nip includes at least one of the two pressure roller **22** (*e.g.,* **22a**), the surface against which pressure is applied may be referred to as an opposing surface or a backing surface **36,** which as mentioned can be a second pressure roller (*e.g.,* **22b**) or a backing support **34,** and may provide for a static or a dynamic surface upon closing of the nip in operation of the system.

Figures 5A and 5B illustrate a number of nip configurations in a highly schematic manner. **Figure 5A** depicts a system wherein a substrate **10** is fed to a nip **40A** in the direction of the arrow, to receive on its two sides substance patterns delivered respectively by webs **14a** and **14b,** each being supplied by a supply roll **16a** or **16b** and ultimately taken up by rewound rolls **32a** or **32b,** accordingly. The substrate **10** is fed to nip **40A** formed by two pressure rollers **22a** and **22b** via a feeding mechanism **55** to be later detailed and exits the nip following transfer of patterns as **10'.**

**Figure 5B** depicts alternative systems wherein a substrate **10** is fed to a nip **40B** in the direction of the arrow, to receive on a single one of its two sides substance patterns delivered by web **14a** being supplied by a supply roll **16a** and taken up by rewound roll **32a.** The substrate is fed to nip **40B** formed by pressure roller **22a** and backing support **34** via a feeding mechanism **55a.** The substrate may optionally sequentially enter a second nip **40C** formed by pressure roller **22b** and backing surface **36** via a feeding mechanism **55b.** Nip **40C** allows for the application of a second substance pattern on the other side of the substrate, the second patterns being delivered by web **14b** supplied by a supply roll **16b** and taken up by rewound roll **32b.** Nips **40A** and **40B** are examples of nip **40C** and while the configuration of nip **40A** may be preferred for synchronous application of substance patterns on both sides of a substrate, all three configurations may be used to apply a pattern on a single side of the substrate or to sequentially apply a patten one side at a time.

Regardless of nip configuration, the pressure rollers **22** (**22a and 22b**) and backing surfaces **36** (*e.g.,* backing supports **34**) composing the nip **40** may be configured to suit the webs and substrates intended to pass therebetween. For instance, they may form suitable gaps, or have suitable dimensions, shapes or surface topography, suitable friction properties, suitable compressibility (*e.g.,* to urge intimate contact between the web and a face of the substrate), suitable hardness (*e.g.,* adapted to the substrate mechanical properties), and like considerations readily appreciated by a skilled person. Such properties of the pressure rollers or backing supports may be inherent to the part or provided by a suitable coating of the part.

In some embodiments, pressure roller **22** (**22a or 22b**) (or a backing support thereto) can be coated with a material (*e.g*., a polymeric compound or blend) so as to provide on its outer surface an external layer **25** having a hardness of no more than 100 Shore A, no more than 90 Shore A, no more than 80 Shore A, no more than 70 Shore A, no more than 60 Shore A, no more than 50 Shore A, or no more than 40 Shore A. In some embodiments, pressure roller **22** (**22a or 22b**) has an outer surface hardness of at least 10 Shore 00, at least 30 Shore 00, at least 50 Shore 00 (which approximately correspond to 10 Shore A), at least 20 Shore A, or at least 30 Shore A.

In some embodiments, pressure roller **22** (**22a or 22b**) (or a backing support thereto) can be coated with a material so as to provide on its outer surface an external layer **25** alternatively or additionally serving as a compressible layer adapted to ensure the proper contacting of the surfaces of the web and the substrate.

**Figure 6** schematically illustrates these alternatives of having a pressure roller **22** or a backing surface **36** uncoated or coated with an external layer **25.** For the sake of the possible combinations of the same, being depicted by nips **401** to **407,** the coated versions of the pressure roller and the backing surface shall be referred to in this figure by **22'** and **36'** respectively.

The parts forming the nips (*e.g*., pressure roller **22** and backing surface **36**) are preferably capable of disengagement one from another, allowing for instance to adjust a distance between them (*e.g*., moving at least one of the two pressure rollers **22a** and **22b** one toward or away from the other), such as for adapting the nip gap to the substrate and/or webs thickness, or for threading a web, or for removing a misfed substrate, and like conventional operation and maintenance that may be required at a nip.

As closing of a nip to form a gap suitable for transfer may cause a mild (typically backward) displacement of the web contacted by the part being moved, the webs may be accordingly positioned prior to closing to take this phenomenon into account. For instance, one of the two webs **14** (**14a and 14b**) may be intentionally advanced with respect to the other in a manner which causes the patterns carried by the webs to be non-aligned prior to the closing of nip **40,** so that the webs and their respective pattens be correctly aligned (*e.g*., within tolerance) upon closing of the nip. The extent of intentional pre-nip-closing misalignment due to provide correct alignment following nip closing can be calculated based on nip configuration and operation or can be empirically determined. Correct alignment following closing of the nip can be determined visually prior to starting or restarting the web drive mechanisms or with the assistance of suitable sensors in operation of the apparatus.

The cooling of the substrates to which the webs are still attached in the cooling station **23** is effected in the illustrative figure by an endless belt **24** (**24a or 24b**) that also passes through the nip between the rollers **22** (**22a and 22b**) and the nip between the rollers **26** (**26a and 26b**) and further passes over an idler roller **28** (**28a or 28b**). Other cooling methods and devices may be alternatively used for this purpose. In some of such methods and devices, rollers **26** (**26a and 26b**) may be omitted. In an alternative approach, the web (and in turn to some extent the substrate) may be cooled by conduction by being brought into thermal contact with a "static" heat sink (*e.g.,* a conventional heat exchanger passively or actively refrigerated by a fluid, and optionally including a number of fins to facilitate heat dissipation). For example, the heat sink may extend between the nip and a point on the path at which the web is separated from the substrate (*e.g*., by separating device or by web forming an angle with the substrate sufficient to achieve separation). The web(s) and/or the substrate may be maintained in thermal contact with the heat sink by way of one or more rollers urging such contact. In some embodiments, these roller(s) may additionally act as a portion of the heat sink. For instance, such rollers may optionally be cooled (*e.g.,* liquid cooled).

Regardless of the means and methods used to cool the web(s) and/or the substrate, such cooling is adapted so that the web reaches the separation point (*e.g.,* the separating device) at a particular temperature, so as to facilitate the separation of the web away from the substrate and/or the adhesion of the pattern of composition to the surface of the substrate. Without wishing to be bound by any particular theory, it is believed that peeling the web from the substrate at a temperature below the softening temperature of the web and below the softening temperature of the composition (*e.g*., the softening temperature of polymers comprised in the composition, for instance adhesives and in particular thermally activated ones) may assist these processes. For example, the temperature of the web following cooling and upon separation can be at most 60°C, at most 50°C, or at most 40°C.

Following this rationale, a cooling station may, in some embodiments, not be necessary to the apparatus. For instance, if the transfer is effected at relatively moderate temperatures at which the pattern may sufficiently transfer to the substrate and attach thereto, a cooling step may not be required. This can the case, for instance, if the adhesive of the composition is a pressure sensitive adhesive, or if an additional adhesive is applied to the substrate, the webs, or selected regions thereof.

When using the apparatus shown in Figure 1 at elevated speed, damage (*e.g*., breakage) of substrates **10,** when thin and brittle, was observed in a commercially significant proportion. While breakage of relatively fragile substrates can be reduced or prevented by uniform speed reduction of the apparatus, such approach accordingly reduces productivity. The present disclosure provides an alternative feed mechanism that is intended to replace corresponding components upstream of the nip **40** to achieve a lower breakage rate, preferably less than 1.5%. While the feed mechanism of the present invention is advantageous for relatively fragile substrates, its use need not be limited to such substrates, since being capable of transferring patterns at relatively high velocities increases productivity regardless of the substrate type. The apparatus downstream of the nip **40,** which can be, for instance, essentially as described in WO 2018/020483 and US 2019/0174635, may be retained without modification or be adapted as described herein.

Likewise, components upstream of the nip only facilitating the operation of the alternative feed mechanism according to the present teachings, or not being related thereto, may be preserved. For instance, a subsystem ensuring the timely delivery of a pattern carried by a flexible web can be similar in principle and architecture to one previously described by the Applicant, or otherwise known in part from the art, or adapted as further described herein. Such known components shall not be detailed herein and interested readers are referred *inter alia* to WO 2018/020483 and US 2019/0174635, which are incorporated by reference in their entirety as is fully set forth herein. New architectures will be described in following sections.

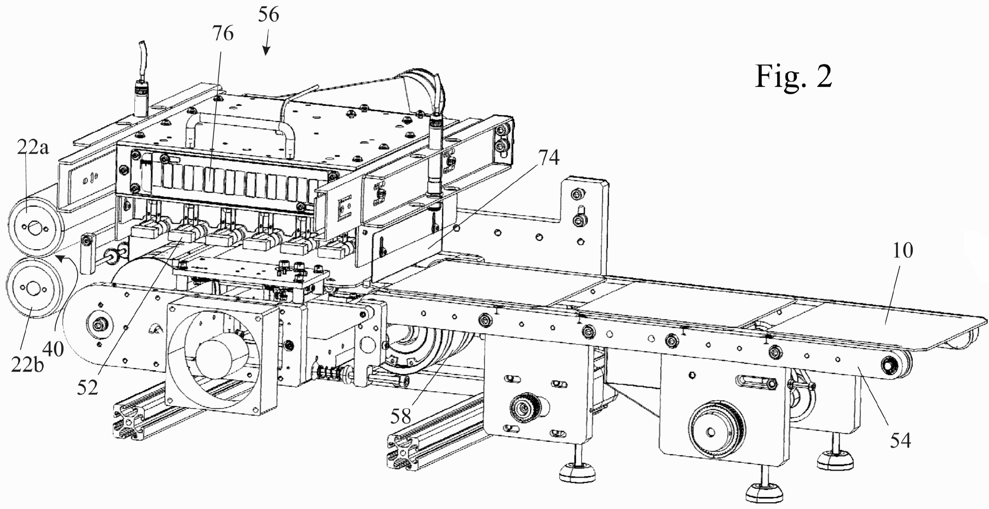

**Figures 2 to 4** show an apparatus **56** for feeding substrates **10** to a nip **40** between two rollers **22a** and **22b** such as described above. The apparatus comprises two separately driven conveyors, herein termed a feeding (or feed) conveyor **54** and a transportation (or transport) conveyor **58,** to distinguish them from one another. The purpose of the feeding conveyor is to transfer substrates **10,** one at a time from a suitable supply, such as a stack or a cassette, to a location at which they can be picked up by the transportation conveyor **58.** The purpose of the transportation conveyor **58** is first to establish an exact positioning (*e.g*., by way of a sensor detecting the positioning) of each substrate **10** and then to advance the substrate **10** at a predetermined speed to the nip **40** for it to arrive at the nip **40** at a time that is synchronised with the motion of the webs carrying the substrate patterns, so as to achieve correct registration between the patterns and the substrates.

As readily appreciated by persons skilled in registration of patterns on a surface or with respect to one another, such matters typically allow for some tolerance which may be expressed in relative terms (*e.g.,* percentage of deviation) or in absolute terms (*e.g.,* distance from intended positioning). For example, in the case of functional patterns, a registration may be deemed correct if within a tolerance of +/- 100 micrometre (µm) or less, or +/- 75 µm or less, or +/- 50 µm or less from exact positioning. For illustration, the patterns are correctly registered if within +/- 50 µm in each of the X-direction (the direction of movement of the conveyors **54** and **58**) and the transverse Y-direction from the desired positioning with respect to the various (leading, trailing, right and left) edges of the substrate and, if patterns are applied on both the top and bottom surfaces of the substrate, if within +/- 50 µm in each of the X-direction and Y-direction from the desired positioning with respect to one another. In the case of purely ornamental patterns, such tolerance can be further relaxed and a patten applied within a few millimetres (mm) from its intended position may still be correctly registered if visually satisfactory for its desired decorative purpose.

The speed of the feeding conveyor **54** is controlled through an electric motor with its speed monitored using an encoder. The feeding conveyor **54** may comprise two spaced apart cyclically movable endless belts running parallel to one another, each side edge of the substrate **10** resting on, and supported by, a respective one of the two belts. As such, the belts should be spaced apart less than the width of the substrate **10** to be transported. The substrates **10** may be delivered to the feeding conveyor **54** by drawing substrates **10** from a stack or cassette or by a further station upstream of the feeding conveyor **54.**

The reason that the feeding conveyor **54** is formed of two separate belts is that, at its downstream end, the two belts straddle the upstream end of the transportation conveyor **58** creating an overlap region at which the individual substrates are transferred from the feeding conveyor **54** to the transportation conveyor **58.** The transfer between the conveyors is described in more detail below with respect to one embodiment wherein the feeding conveyor is in a plane higher than the plane of the transportation conveyor, the substrates being individually lowered from the former to the latter conveyor. The skilled person would know how to adapt the apparatus for the converse case of the feeding conveyor being in a plane lower than the plane of the transportation conveyor, the substrates being individually lifted up from the former to the latter conveyor.

In some embodiments, one or more of inspecting, selecting, laser doping or any other process may be carried out while the substrates **10** lie on the feeding conveyor **54.** In other embodiments, the feeding conveyor **54** acts purely as a means of transferring substrates **10** from a stack or cassette to a transportation station, generally designated **56.**

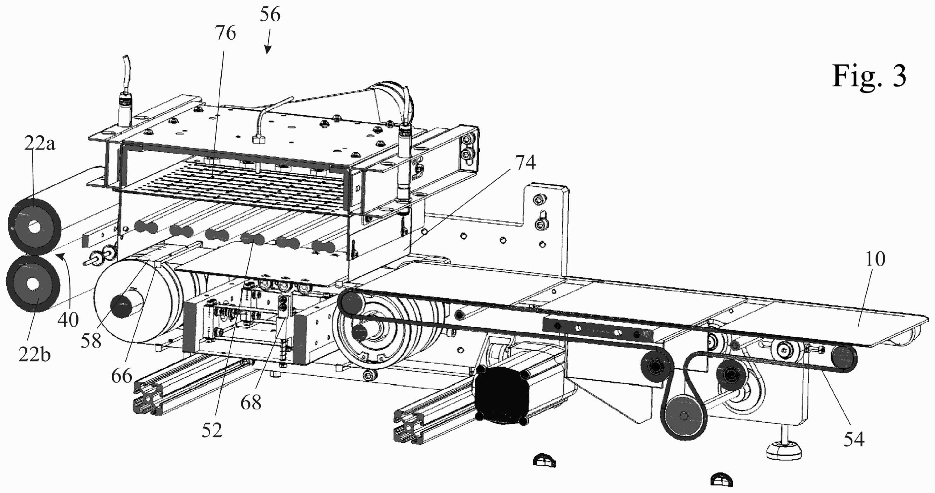

The transportation station **56** comprises the transportation conveyor **58,** the latter being formed as an endless belt having at least one projection **66,** which is shown in Figure 3 as a bar **66** extending transversely, *e.g*., across the entire width of the belt, any other dimension adapted to the size and/or intended position of the substrate being acceptable. For instance, the projection may be shaped as a pin located across the width of the conveyor to suitably contact the substrate, such projection being optionally capable of facilitating the registration of the substrate with respect to the nip. The projections are intended to engage the trailing edge of a substrate **10** being advanced towards the nip **40.** Because the substrates are advanced by pushing them from their rear edge, rather than relying on the friction of the conveyor, the position of each substrate is accurately determined as it is being advanced towards the nip **40.** The transportation conveyor **58** may be dimensioned to have only a few (*e.g.,* 2, 3...) projections over its entire circumference, so that only a single whole substrate **10** can be transported by it at any one time towards the nip **40.** This may be desirable for a number of reasons, including preventing the registration between one substrate **10** and the web affecting the next, and minimising loss of substrates in the event of a shutdown.

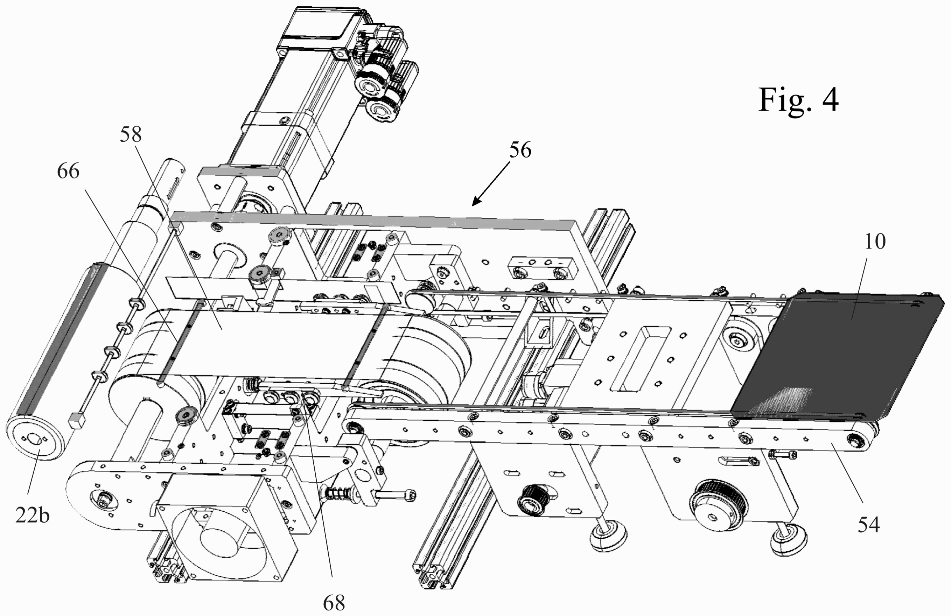

In the exemplary illustrated embodiment, the plane of the feeding conveyor **54** is higher than that of the transportation conveyor **58,** but this should not be construed as limiting. In the overlap region, the feeding conveyor drives substrates onto a lifting mechanism **68** (best seen in **Figures 3** and **4**) that supports a single substrate by its lateral edges in a plane higher than that of the transportation conveyor **58.** After a substrate **10** has been loaded onto it by the feeding conveyor **54,** the lifting mechanism **68** lowers the substrate that it supports to a position, above the plane of the transportation conveyor, where it will collide with a projection **66** on the transportation belt, resulting in the substrate **10** sliding off the lifting mechanism **68** and onto the belt of the transportation conveyor **58,** with its trailing edge in contact with the projection **66.** The lifting mechanism **68** moves in synchronism with the transportation conveyor **58** so that it only moves to its lower position at times when there is no projection located beneath it. This can be achieved, for example, by the lifting mechanism **68** being operated by a cam rotated in synchronism with transportation belt, or by initiating descent of an independently driven lifting mechanism **68** by means of a sensor associated with the transportation conveyor **58.**

To decrease the chance of the substrate **10** breaking on colliding with a bar **66,** the frame of the lifting mechanism **68** on which the substrate sits may have a low coefficient of friction. This may be achieved using low friction interface obtained with bearing elements, by treating or coating the lifting mechanism **68** with a low friction material, or simply by polishing the frame of the lifting mechanism **68.**

The speed of the transportation conveyor **58,** as well as the speed of the web **14** (**14a or 14b**)**,** may be varied to synchronise the substrate **10** and the pattern on the web **14** (**14a or 14b**).

Sensors may be disposed in the transportation station **56** to monitor the position of the projections **66** and/or the substrate **10,** and particularly its leading edge. In the case of two webs being used to apply a pattern to opposite sides of the substrate **10,** at least one of the webs may be driven at a constant surface speed. The speed of the transportation conveyor **58** is lower than the surface speed of the web(s) at the nip **40** to ensure that as the leading edge of the substrate **10** contacts the nip **40,** it is pulled away from the projection **66.** Were the speed of the transportation conveyor **58** to exceed the speed of passage of the substrate through the nip **40,** the projection **66** would impart a compressive force to the substrate in a lengthways direction, which in turn might increase the risk of breakage. As readily appreciated, the present teachings therefore relate to an apparatus (and related method) wherein the nip grips the leading edge of the substrate in absence, at such time, of any force from the transport conveyor that would result in compression being applied to the edges of the substrate. The edges of the substrate along the X- and Y-direction are typically more fragile than more central portions of the substrate and the present apparatus may therefore preserve their integrity, the substrate being robust enough to be subjected to, and/or the nip being adapted to apply, a compression in the Z-direction high enough to ensure transfer and low enough to prevent breakage.

Correct alignment between the pattern carried by a web and the substrate onto which it is to be transferred, in the X-direction as defined above, is ensured by correctly timing the movement of the transportation conveyor. Alignment in the transverse Y-direction may be ensured by urging the substrate, in the transverse direction, while it is on the transportation conveyor **58.** Because of the positive engagement of the trailing edge of a substrate with a projection **66** of the transportation conveyor, there is no risk of the action of aligning the substrate in the Y-direction interfering with position of the substrate in the X-direction.

If the projection **66** on the transportation conveyor contacts with the trailing edge of a substrate at more than one point and the element urging the substrate against a guide to achieve alignment in the Y-direction also makes contact with the side edge of the substrate at more than point, then there is a risk of the substrate being skewed (rotating about a vertical axis) while trying the achieve alignment in the Y-direction. In order to ensure that the substrate arrives at the nip with a desired orientation, it is preferable for the projection **66** to make only point contact with the trailing edge of the substrate, and to provide two or more pushers positioned on one side of the transportation conveyor to urge the substrate against an elongate guide surface positioned on the opposite side of the transportation conveyor. The guide surface can be a continuous bar having a low friction surface or a series of rollers in sufficient proximity one to another (*e.g.,* in rolling contact), so as to constitute an elongate guide surface. The pushers can be spaced from one another in the direction of travel of the substrate and may comprise rollers urged towards the substrate by means of springs. The spacing of the pushers and the timing of their contacting a lateral edge of the substrate are adapted to prevent the pushers from contacting corners of the substrates, which can be relatively more fragile. The engagement and disengagement of the pushers with the substrate can be controlled by a cam system referred to the position of the substrate along the X-direction.

Such an arrangement will ensure that one side of the substrate will make contact at two points with the guide surface and at only one point with the projection on the transportation conveyor. When there are only three contact points, the risk of skewing of the substrate is avoided. The pushers facilitate the registration of the substrate in the Y-direction, while the projection contributes to the registration of the substrate in the X-direction, such registration of the substrate in X- and Y-directions being with respect to the nip.

If a pattern is to be applied on a single side of the substrate, the registration of the web with respect to the nip may be superfluous, as long as a proper registration of the substrate ensures proper timing of transfer, hence positioning of the pattern on one side of the substrate. Still, tension rollers along the path of the web may facilitate such alignment between the substrate and the pattern to be transferred. When patterns are to be applied on both sides from two webs, either at two subsequent nips but more typically at a same nip, then tension rollers along the path of at least one of the two webs is required to ensure proper alignment, at least of the two webs one with another. The presence of tension rollers along each of the paths of both webs may further facilitate the process.

It should be mentioned in this context that because of the rigidity of certain substrates, notably semiconductor wafers, even when a straight edge of a substrate is urged against a straight guide, there will only be two points of contact at which force is transferred from one to the other.

If one were merely to allow substrates to transfer at random times between the feed conveyor and the transport conveyor, in the overlap region between the two conveyors, there would be a risk of a substrate at least partially resting on the top of one of the projections **66.** The lifting mechanism **68** described above is intended to safeguard against such an eventuality. The lifting mechanism maintains each substrate clear of the projections **66** and lowers it in synchronism with the movement of the transportation belt **58** to ensure that it is picked up by the next projection to pass the lifting mechanism.

The use a lifting mechanism is only one way of overcoming the problem of disparity in speed between feeding and transportation conveyors, while ensuring that a projection contact the trailing edge of the substrate. In an alternative embodiment, there may be provided an overlap region between the two conveyors **54, 58** and a friction element on the transport conveyor may engage a substrate **10** upon transfer from the feeding conveyor **54** to the transportation conveyor **58** to reduce its speed and ensure that a projection **66** of the transportation conveyor **58** should contact the trailing edge of the substrate. Correct timing of the two conveyors **54** and **58** would prevent the substrate from landing on a projection during the transfer. Suitable timing ensures that the substrates can be individually fed (placed onto the transport conveyor) in a volume swept by the projections.

The distance between projections along the length of the conveyor belt in X-direction needs to be sufficient for friction element/lifting mechanism to work correctly. The distance between the projections flanking a feeding volume needs to be at least 10% greater than dimension of the substrate.

The lifting mechanism can also prevent the substrate that is currently on it from being affected by the registration of the substrate on the transportation conveyor- *i.e*. by only lowering the substrate after the leading edge of the substrate before it has entered the nip, as mentioned above. This is an important advantage of a lifting mechanism over a friction element.

A presence sensor may be provided between the feeder and transportation conveyors, to commence movement of the transportation conveyor **58** when a substrate is detected in the feeder conveyor **54.** The presence sensor can be used to adjust the speed of the feeder conveyor **54** to ensure that substrates are fed onto the transportation conveyor **58** at the right time (*e.g.,* with respect to the position of a projection able to engage a trailing edge of a substrate transferred from the feeding to the transportation conveyor). Additional sensors can be provided to assess the registration of the substrate with respect to the nip and synchronize the arrival of its leading edge with the desired positioning of a pattern to be transferred thereto from a web.

The lifting mechanism **68** maybe a cam and follower mechanism, a piston mechanism, or any other mechanism known in the art.

Alternatively, or as a secondary check, a system (not shown) may be installed further downstream to straddle the transportation conveyor **58.** Such a system may comprise one or more guide rails to correctly align the substrates **10.** If installed in addition to the pushers that can be used to facilitate the alignment of the substrates in the Y-direction, the guide rail(s) may be positioned upstream of the pushers to provide a preliminary alignment.

The transportation station **56** may further comprise a heater **52** which can serve to heat the substrate **10** to a desired temperature prior to its entry into the nip. In a similar manner, a heater may be positioned along the path of the web to raise its temperature prior to contacting the substrate. Alternatively, or additionally, if an adhesive coating is applied on the substrate or on a web, or on selected regions thereof, and if the adhesive used in such coating is heat activatable (optionally in addition to being pressure activatable), then a heater may be positioned downstream an applicator adapted to apply the adhesive coating.

The desired temperature at any of these locations may be one that may activate the adhesive in the composition carried by the web **14** (**14a or 14b**), for instance if the composition includes an adhesive which is thermally activated, and need not be the same for the substrate and each of the webs. The appropriate heating temperature will depend on the nature of the composition and the adhesive, and the materials the webs and substrates are made of and is discussed in more detail in WO 2018/020479 and US 2019/0172967. By way of illustration, the heating temperature may depend upon the softening temperature of the composition and of adhesives therein, and may therefore differ for each side of a same substrate the patterns being applied from different webs optionally comprising distinct substances and/or arrangements thereof. In embodiments where heaters are utilized, care is taken to configure any necessary apparatus and parts thereof (*e.g*., contacting or adjacent the heated web and/or heated substrate) to withstand the heat without distortion or failure.

The heating may take different forms depending on the temperature to be reached and can be by conduction, convection or radiation. While webs can also be heated by radiation as described in the following with respect to the substrates, they are typically heated, when desired, with hot air or by contact with heated elements (*e.g*., heated rollers).

In embodiments where the substrate is heated by radiation, the heater **52** may include one or more infrared lamps positioned above and/or below the transportation conveyor **58.** Heating lamps positioned on both sides of the substrate **10** may be utilised together when the substrate **10** is thick, *e.g.,* over about 1mm, to ensure even heating. Where such heating is required, the transportation conveyor **58** may be split much like the feeding conveyor **54,** *i.e.* it may comprise two thin synchronised belts each supporting one side of the substrate, and each may comprise respective projections to push the substrate **10** from both sides.

In some embodiments, the infrared lamps comprised in heater **52** may be configured to collectively emit radiation that is equivalent to about 6 kW, 12 kW, 24 kW or any other appropriate amount of radiation. Shields **74** may be provided to block the radiation from the lamps reaching outside the heating area. A cooling apparatus **76** may be provided to prevent overheating of the shields. The cooling apparatus may comprise air cooling components or any other means known in the art.

While heating can be performed upstream of the nip for the web(s) and/or substrate, it can alternatively or additionally be performed at the nip. For instance, the pressure roller **22** (**22a or 22b**) may, in some embodiments, additionally serve as a heating roller. Heating the web and/or the substrate upstream of the nip may obviate the need for any heating of the nip or it may allow for heating the nip to a lower temperature. In some embodiments, the heating may occur even prior to the transportation station **56,** although the nearer to the nip **40** that the heating occurs, the more efficient the process. If performed at more than one location and/or towards more than one the substrate and one of the webs, the different heating temperatures that may be set to provide a gradual change in temperatures as the substrate and the web(s) proceed to a nip. Such gradients can be selected to avoid too rapid a rise, or conversely too rapid a drop, in temperature which may adversely affect the transfer of a pattern from a web to an intended surface of the substrate. Temperature sensors may be incorporated into the apparatus to ensure temperatures are within an acceptable range, and controllers (manual or computer controlled) provided to keep the temperatures within their respectively acceptable ranges.

As mentioned above, only one substrate **10** may, in some embodiments, be placed on the transportation conveyor **58** at any one time so that waste is minimised in the event of a shutdown. For example, if a shutdown occurs whilst a substrate **10** is part way through the heater, the substrate may be considered scrap if it has only been partially heated and then allowed to cool, or if it has been overheated due to the conveyor **58** stopping in the heating area. This may be mitigated by using a shutdown procedure where each station is shutdown sequentially as it passes a final substrate **10** on to the next station. For example, the transportation station **56** may only shutdown once the leading edge of the final substrate **10** has entered the nip **40.** In a such a case, a few of the substrates salvaged from irreversible processing by this sequential shutdown need not be wasted and could be recycled.

Following passage through the nip, the web can be separated (*e.g*., peeled away) from the substrate, such separation, if occurring, completing the transfer of the substance pattern from a web to the substrate. The substrate and the web(s) may be cooled downstream of the nip to assist separation. As the cooling is believed to accelerate or otherwise facilitate the adherence of the substance pattern to the substrate and/or ease the release of the pattern from the flexible web, the appropriate cooling temperature and/or cooling rate will depend on the nature of the composition and of its components. Regardless of the means employed to ensure cooling of the substrates and/or webs, the site and/or device where such cooling takes place, if desired, can be referred to as a cooling station.

The separation device **30** illustrated in the exemplary embodiment of the depicted apparatus comprises a metal plate that is bent about a small radius to define an acute angle. The web on its return path to the take-up roller **32** is bent over the sharp edge defined by the outer sides of the bent metal plate. This action peels the web **14** (**14a or 14b**) away from the substrate **10** leaving the composition adhering to the substrate **10.** A skilled person will readily appreciate that similar satisfactory peeling of the web **14** (**14a or 14b**) can be achieved by the angle formed between the path of web **14** (**14a or 14b**) and the path of substrate **10** or by alternative separation devices. Regardless of the means employed to ensure peeling of the web from the surface of the substrate, the site and/or device where such separation takes place, if desired, can be referred to as a separation or separating station. The cooling station and separation station are non-limiting examples of stations downstream of the nip where the substrates and the webs can be subjected to any desired action, these stations being also referred to as post-transfer stations.

The substrate now bearing at least part of a desired pattern on at least one of its sides can, if needed, be further treated. For instance, it may be exposed to energy in an amount sufficient to cause sintering and/or fusing of metal particles contained in the substance so as to render the transferred pattern conductive, it may be cured by radiation if the substance includes a curable material that may further adherence to the substrate. In the event that a web is not peeled away from the substrate, the treatment taking place following the nip may include separating between individual substrates that would be otherwise "linked" by way of attachment to a common web (*e.g.,* by cutting the web in-between adjacent substrates). Such post-treatment can be performed off-line in a separate apparatus (*e.g*., a solar cell furnace) or in-line with an apparatus according to the present teachings. A variety of post-treatments exist depending on the substrate, the transferred pattern and the intended use, and are known to the skilled persons, hence shall not be herein detailed. The sites or devices where such post-treatment of the substrates and the webs may take place, whether still attached one to another or separated, can be referred to as post-treatment stations. Post-treatment stations can be considered another kind of post-transfer stations.

Although the present disclosure has been described with respect to various specific embodiments presented thereof for the sake of illustration only, such specifically disclosed embodiments should not be considered limiting.

It is therefore to be understood that the foregoing description including the specifically described apparatuses are merely exemplary of the presently disclosed subject matter, are presented for the sake of illustration only, and are therefore not intended to be necessarily limiting. Furthermore, all examples, embodiments, implementations, cases, instances, figures/illustrations, *etc.* of such features described herein should be understood to be non-limiting. Many other alternatives, modifications, alterations, permutations, and variations of such features will be apparent to those skilled in the art based upon the disclosure herein. Accordingly, it is intended to embrace all such alternatives, modifications and variations, and any change which come within their meaning and range of equivalency.

The word "exemplary" is used herein to mean "serving as an example, instance or illustration". Any example, embodiment, case, instance, or figure/illustration of a certain feature described as "exemplary" is not necessarily to be construed as preferred or advantageous over other embodiments and/or to exclude the incorporation of one or more features from other embodiments. Furthermore, a feature which is described as preferred or advantageous in some embodiments, may not necessarily be preferred or advantageous in other embodiments.

It is appreciated that certain features of the presently disclosed subject matter, which are, for clarity, described in the context of different embodiments, may also be provided in combination in the same embodiment or embodiments. Conversely, various features of the presently disclosed subject matter, which are, for brevity, described in the context of the same embodiment or embodiments, may also be provided separately or in any suitable subcombination or as suitable in any other described embodiment of the presently disclosed subject matter. Certain features described in the context of an embodiment are not to be considered essential features of the embodiment, unless the embodiment is inoperative without those features.

Unless otherwise defined or understood from the disclosure herein, all technical and scientific terms used herein have the same meaning as commonly understood by one of ordinary skill in the art to which the present disclosure pertains.

Unless otherwise stated, the use of the expression "and/or" between the last two members of a list of options for selection indicates that a selection of one or more of the listed options is appropriate and may be made.

In the description and claims of the present disclosure, each of the verbs "comprise", "include" and "have", and conjugates thereof, are used to indicate that the object or objects of the verb are not necessarily a complete listing.

As used herein, the singular form "a", "an" and "the" include plural references and mean "at least one" or "one or more" unless the context clearly dictates otherwise.

As used herein, the term at least one of A and B is intended to mean either A or B, and may mean, in some embodiments, A and B.

Positional or motional terms such as "upper", "lower", "right", "left", "bottom", "back", "front", "below", "lowered", "low", "top", "above", "elevated", "high", "vertical", "side", "horizontal", "backward", "forward", "upstream" and "downstream", as well as grammatical variations thereof, may be used herein for exemplary purposes only, to illustrate the relative positioning, placement or displacement of certain objects (*e.g*., components in an apparatus), to indicate a first and a second object or to do both. Such terms do not necessarily indicate that, for example, a "bottom" object is below a "top" object, as such directions, components or both may be flipped, rotated, moved in space, placed in a diagonal orientation or position, placed horizontally or vertically, or similarly modified.

Unless otherwise stated, when the outer bounds of a range with respect to a feature of an embodiment of the present disclosure are noted herein, it should be understood that in the embodiment, the possible values of the feature may include the noted outer bounds as well as values in between the noted outer bounds. Herein, unless otherwise stated, adjectives such as "substantially", "approximately" and "about" that modify a condition or relationship characteristic of a feature or features of an embodiment of the presently disclosed subject matter, are to be understood to mean that the condition or characteristic is defined to within tolerances that are acceptable for operation of the embodiment for an application for which it is intended, or within variations expected from the measurement being performed and/or from the measuring instrument being used. For example, when the term "about" and "approximately" precedes a numerical value, it may indicate +/-15%, or +/-10%, or even only +/-5%, or any other suitable +/- variation within such ranges, and in some instances may indicate the precise value. Furthermore, unless otherwise stated, the terms (*e.g*., numbers) used in an embodiment of the presently disclosed subject matter, even without such adjectives, should be construed as having tolerances which may depart from the precise meaning of the relevant term but would enable the embodiment or a relevant portion thereof to operate and function as described, and/or as understood by a person skilled in the art.

The invention is defined by the appended claims.

Some embodiments may be considered as long as they belong to the scope of the invention.

## Claims

1. A system for transferring a substance pattern to a substrate (10), the system comprising
a web (14 (14a or 14b)) carrying the substance pattern, a web drive mechanism for driving the web through a nip (40) between a pressure roller (22 (22a or 22b)) and an opposing surface, and a transport conveyor (58) for advancing a substrate towards the nip for the substrate to be gripped in the nip and frictionally driven through the nip at the same time, and with the same speed, as the web, the web being pressed against a surface of the substrate during passage through the nip to cause the substance pattern to transfer from the web to the substrate, **characterised in that** at least one projection (66) is provided on the transport conveyor to engage a trailing edge of the substrate and the transport conveyor is driven to advance the substrate towards the nip with a speed lower than that of the web, whereby the trailing edge of the substrate automatically disengages from the projection upon engagement of the leading edge of the substrate within the nip, thereby avoiding compression of the substrate.

2. A system as claimed in claim 1, wherein a feed conveyor (54) is provided to place
substrates individually into a volume swept by the projections of the transport conveyor so that the trailing edge of the substrate is engaged by a projection of the transport conveyor and thereby loaded onto the transport conveyor.

3. A system as claimed in claim 2, wherein the feed conveyor and the transport conveyor overlap and straddle one another at an end of the transport conveyor distal from the nip.

4. A system as claimed in claim 2 or claim 3, wherein the transport conveyor includes a friction element engaging the substrate and thereby reducing a speed of the substrate till engagement with a projection.

5. A system as claimed in any one of claim 2 to claim 4, wherein at least one of the transport conveyor and the feed conveyor is formed of two parallel belts and the feed conveyor carries the substrates in a plane different than that of the transport conveyor, a lifting mechanism (68)
being provided to raise, or to lower, substrates individually from the feed conveyor into the volume swept by the projections of the transport conveyor.

6. A system as claimed in claim 5, wherein a low friction interface obtained with bearing elements, by treating or coating the lifting mechanism with a low friction material, or simply by polishing the frame of the lifting mechanism,
exists between the substrate and the lifting mechanism for ensuring that minimal stress is placed on the substrate on making contact with a projection of the transport conveyor.

7. A system as claimed in any one of the preceding claims, wherein two or more pushers, spaced from one another in an X-direction of travel of the substrate, are positioned on one side of the transport conveyor to urge the substrate in a Y-direction traverse to the X-direction against an elongate guide surface positioned on the opposite side of the transport conveyor.

8. A system as claimed in any one of the preceding claims, wherein the opposing surface of the nip is stationary.

9. A system as claimed in any one of claim 1 to claim 7, wherein the roller is a first pressure roller (22a) and the opposing surface is formed by a second pressure roller (22b), two webs (14a, 14b) passing through the nip at the same time with the substrate, the two webs being constituted of a first web (14a) carrying a first substance pattern and a second web (14b) carrying a second substance pattern, the first and second substance patterns being transferred to opposite sides of the substrate.

10. A system as claimed in claim 9, further comprising at least one tension roller along a path of at least one of the two webs, the at least one tension roller being adapted to address X-registration of the at least one web with respect to the other of the two webs.

11. A system as claimed in any one of the preceding claims, further comprising a heater (52) for heating substrates supported by the transport conveyor and/or the web(s) prior to reaching the nip.

12. A system as claimed in any one of the preceding claims, further comprising an applicator for applying an adhesive to at least one of the substrates and the webs prior to reaching the nip or prior to passage through a heater, when present.

13. A system as claimed in any one of the preceding claims, further comprising at least one post-transfer station downstream of the nip, the at least one post-transfer station being optionally selected from a cooling station (23) adapted to decrease a temperature of the substrates and/or web(s), a separating station adapted to separate the web from a surface of the substrate, and a post-treatment station adapted to modify the substance patterns and/or their adherence to the substrates.

14. A system as claimed in claim 13, wherein the substance patterns include particles of electrically conductive material and at least one post-transfer station is a post-treatment station adapted to sinter the particles, so as to render the pattern electrically conductive.

15. A method of introducing a substrate (10) into a nip (40) defined between a pressure roller (22 (22a or 22b)) and an opposing surface through which the substrate is driven, in which method the substrate is advanced towards the nip (40) by means of a transport conveyor (58) that is configured to cease applying a force to the substrate upon engagement of the leading edge of the substrate within the nip, so as to avoid the substrate being compressed, **characterised in that** the transport conveyor is formed with a projection (66) to engage a trailing edge of the substrate to push the substrate towards the nip, and the speed of the transport conveyor is set to less than the speed passage of the substrate through the nip, such that on entry of the leading edge of the substrate into the nip the trailing edge separates from the projection of the transport conveyor.

## Patentansprüche

1. System zum Übertragen eines Substanzmusters auf ein Substrat (10), wobei das System eine Bahn (14 (14a oder 14b)), die das Substanzmuster trägt, einen Bahnantriebsmechanismus zum Antreiben der Bahn durch einen Walzenspalt (40) zwischen einer Druckrolle (22 (22a oder 22b)) und einer gegenüberliegenden Oberfläche und einen Transportförderer (58) zum Vorschieben eines Substrats zu dem Walzenspalt umfasst, damit das Substrat gleichzeitig und mit der gleichen Geschwindigkeit wie die Bahn in dem Walzenspalt gegriffen und reibschlüssig durch den Walzenspalt getrieben wird, wobei die Bahn während Durchlauf durch den Walzenspalt gegen eine Oberfläche des Substrats gedrückt wird, um zu bewirken, dass das Substanzmuster von der Bahn auf das Substrat übertragen wird, **dadurch gekennzeichnet, dass** zumindest ein Vorsprung (66) auf dem Transportförderer bereitgestellt ist, um eine Hinterkante des Substrats in Eingriff zu nehmen, und der Transportförderer angetrieben wird, um das Substrat zu dem Walzenspalt mit einer Geschwindigkeit vorzuschieben, die niedriger als diejenige der Bahn ist, wodurch sich die Hinterkante des Substrats automatisch von dem Vorsprung bei Eingriff der Vorderkante des Substrats innerhalb des Walzenspalts löst, wodurch Kompression des Substrats vermieden wird.

2. System nach Anspruch 1, wobei ein Zuführförderer (54) bereitgestellt ist, um Substrate einzeln in einem Volumen zu platzieren, das durch die Vorsprünge des Transportförderers überstrichen wird, sodass die Hinterkante des Substrats durch einen Vorsprung des Transportförderers in Eingriff genommen und dadurch auf den Transportförderer geladen wird.

3. System nach Anspruch 2, wobei der Zuführförderer und der Transportförderer einander an einem Ende des Transportförderers distal von dem Walzenspalt überlappen und überspannen.

4. System nach Anspruch 2 oder Anspruch 3, wobei der Transportförderer ein Reibungselement beinhaltet, welches das Substrat in Eingriff nimmt, und dadurch eine Geschwindigkeit des Substrats bis zum Eingriff mit einem Vorsprung reduziert.

5. System nach einem von Anspruch 2 bis Anspruch 4, wobei zumindest eines von dem Transportförderer und dem Zuführförderer aus zwei parallelen Bändern gebildet ist und der Zuführförderer die Substrate in einer Ebene trägt, die sich von derjenigen des Transportförderers unterscheidet, wobei ein Hubmechanismus (68) bereitgestellt ist, um Substrate einzeln von dem Zuführförderer in das Volumen, das durch die Vorsprünge des Transportförderers überstrichen wird, anzuheben oder abzusenken.

6. System nach Anspruch 5, wobei eine reibungsarme Schnittstelle, die mit Lagerelementen erhalten wird, durch Behandeln oder Beschichten des Hubmechanismus mit einem reibungsarmen Material oder einfach durch Polieren des Rahmens des Hubmechanismus zwischen dem Substrat und dem Hubmechanismus existiert, um sicherzustellen, dass minimale Belastung auf dem Substrat bei Herstellung von Kontakt mit einem Vorsprung des Transportförderers platziert wird.

7. System nach einem der vorhergehenden Ansprüche, wobei zwei oder mehr Schieber, voneinander in einer X-Fortbewegungsrichtung des Substrats beabstandet, auf einer Seite des Transportförderers positioniert sind, um das Substrat in einer Y-Richtung quer zu der X-Richtung gegen eine längliche Führungsoberfläche zu drängen, die auf der gegenüberliegenden Seite des Transportförderers positioniert ist.

8. System nach einem der vorhergehenden Ansprüche, wobei die gegenüberliegende Oberfläche des Walzenspaltes stationär ist.

9. System nach einem der Ansprüche 1 bis 7, wobei die Rolle eine erste Druckrolle (22a) ist und die gegenüberliegende Oberfläche durch eine zweite Druckrolle (22b) gebildet ist, wobei zwei Bahnen (14a, 14b) gleichzeitig mit dem Substrat den Walzenspalt durchlaufen, wobei die zwei Bahnen aus einer ersten Bahn (14a), die ein erstes Substanzmuster trägt, und einer zweiten Bahn (14b), die ein zweites Substanzmuster trägt, bestehen, wobei das erste und das zweite Substanzmuster auf gegenüberliegende Seiten des Substrats übertragen werden.

10. System nach Anspruch 9, ferner umfassend zumindest eine Spannrolle entlang eines Weges von zumindest einer der zwei Bahnen, wobei die zumindest eine Spannrolle dazu ausgelegt ist, X-Registrierung der zumindest einen Bahn in Bezug auf die andere der zwei Bahnen zu adressieren.

11. System nach einem der vorhergehenden Ansprüche, ferner umfassend eine Heizung (52) zum Erhitzen von Substraten, die durch den Transportförderer und/oder die Bahn(en) gestützt werden, bevor der Walzenspalt erreicht wird.

12. System nach einem der vorhergehenden Ansprüche, ferner umfassend einen Applikator zum Applizieren eines Klebstoffes auf zumindest eines von den Substraten und den Bahnen vor dem Erreichen des Walzenspalts oder vor einem Durchlauf durch eine Heizung, wenn vorhanden.

13. System nach einem der vorhergehenden Ansprüche, ferner umfassend zumindest eine Nachübertragungsstation stromabwärts des Walzenspalts, wobei die zumindest eine Nachübertragungsstation optional ausgewählt ist aus einer Kühlstation (23), die dazu ausgelegt ist, eine Temperatur der Substrate und/oder der Bahn(en) zu verringern, einer Trennstation, die dazu ausgelegt ist, die Bahn von einer Oberfläche des Substrats zu trennen, und einer Nachbehandlungsstation, die dazu ausgelegt ist, die Substanzmuster und/oder ihre Haftung an den Substraten zu modifizieren.

14. System nach Anspruch 13, wobei die Substanzmuster Partikel aus elektrisch leitendem Material beinhalten und zumindest eine Nachübertragungsstation eine Nachbehandlungsstation ist, die dazu ausgelegt ist, die Partikel zu sintern, um das Muster elektrisch leitend zu machen.

15. Verfahren zum Einbringen eines Substrats (10) in einen Walzenspalt (40), der zwischen einer Druckrolle (22 (22a oder 22b)) und einer gegenüberliegenden Oberfläche, durch die das Substrat angetrieben wird, definiert ist, wobei in dem Verfahren das Substrat zu dem Walzenspalt (40) mittels eines Transportförderers (58) vorgeschoben wird, der dazu konfiguriert ist, Applizieren einer Kraft auf das Substrat bei Eingriff der Vorderkante des Substrats innerhalb des Walzenspalts zu beenden, um zu vermeiden, dass das Substrat komprimiert wird, **dadurch gekennzeichnet, dass** der Transportförderer mit einem Vorsprung (66) gebildet ist, um eine Hinterkante des Substrats in Eingriff zu nehmen, um das Substrat zu dem Walzenspalt zu drücken, und die Geschwindigkeit des Transportförderers auf weniger als den Geschwindigkeitsdurchlauf des Substrats durch den Walzenspalt eingestellt ist, sodass sich bei Eintritt der Vorderkante des Substrats in den Walzenspalt die Hinterkante von dem Vorsprung des Transportförderers trennt.

## Revendications

1. Système de transfert d'un motif de substance sur un substrat (10), le système comprenant une bande (14 (14a ou 14b)) portant le motif de substance, un mécanisme d'entraînement de bande pour entraîner la bande à travers une zone de pincement (40) entre un rouleau de pression (22 (22a ou 22b)) et une surface opposée, et un convoyeur de transport (58) pour faire avancer un substrat vers la zone de pincement afin que le substrat soit saisi dans la zone de pincement et entraîné par friction à travers la zone de pincement, en même temps et à la même vitesse que la bande, la bande étant pressée contre une surface du substrat pendant le passage à travers la zone de pincement pour provoquer le transfert du motif de substance de la bande vers le substrat, **caractérisé en ce qu'**au moins une saillie (66) est prévue sur le convoyeur de transport pour mettre en prise un bord de fuite du substrat et le convoyeur de transport est entraîné pour faire avancer le substrat vers la zone de pincement à une vitesse inférieure à celle de la bande, moyennant quoi le bord de fuite du substrat se dégage automatiquement de la saillie lors de la mise en prise du bord d'attaque du substrat à l'intérieur de la zone de pincement, évitant ainsi la compression du substrat.

2. Système selon la revendication 1, dans lequel un convoyeur d'alimentation (54) est prévu pour placer des substrats individuellement dans un volume balayé par les saillies du convoyeur de transport de sorte que le bord de fuite du substrat soit mis en prise par une saillie du convoyeur de transport et ainsi chargé sur le convoyeur de transport.

3. Système selon la revendication 2, dans lequel le convoyeur d'alimentation et le convoyeur de transport se chevauchent et s'enjambent à une extrémité du convoyeur de transport distale de la zone de pincement.

4. Système selon la revendication 2 ou la revendication 3, dans lequel le convoyeur de transport comprend un élément de friction venant en prise avec le substrat et réduisant ainsi une vitesse du substrat jusqu'à la mise en prise avec une saillie.

5. Système selon l'une quelconque des revendications 2 à 4, dans lequel au moins l'un du convoyeur de transport et du convoyeur d'alimentation est formé de deux courroies parallèles et le convoyeur d'alimentation porte les substrats dans un plan différent de celui du convoyeur de transport, un mécanisme de levage (68) étant prévu pour lever ou abaisser individuellement des substrats provenant du convoyeur d'alimentation dans le volume balayé par les saillies du convoyeur de transport.

6. Système selon la revendication 5, dans lequel une interface à faible frottement obtenue avec des éléments de palier, par traitement ou revêtement du mécanisme de levage avec un matériau à faible frottement, ou simplement par polissage du cadre du mécanisme de levage, existe entre le substrat et le mécanisme de levage pour s'assurer qu'une contrainte minimale soit exercée sur le substrat lors de la mise en contact avec une saillie du convoyeur de transport.

7. Système selon l'une quelconque des revendications précédentes, dans lequel deux poussoirs ou plus, espacés l'un de l'autre dans une direction X de déplacement du substrat, sont positionnés sur un côté du convoyeur de transport pour pousser le substrat dans une direction Y transversale à la direction X contre une surface de guidage allongée positionnée sur le côté opposé du convoyeur de transport.

8. Système selon l'une quelconque des revendications précédentes, dans lequel la surface opposée de la zone de pincement est stationnaire.

9. Système selon l'une quelconque des revendications 1 à 7, dans lequel le rouleau est un premier rouleau de pression (22a) et la surface opposée est formée par un second rouleau de pression (22b), deux bandes (14a, 14b) traversant la zone de pincement en même temps que le substrat, les deux bandes étant constituées d'une première bande (14a) portant un premier motif de substance et d'une seconde bande (14b) portant un second motif de substance,
les premier et second motifs de substance étant transférés sur des faces opposées du substrat.

10. Système selon la revendication 9, comprenant en outre au moins un rouleau de tension le long d'un trajet d'au moins l'une des deux bandes, l'au moins un rouleau de tension étant adapté pour assurer le calage en X de l'au moins une bande par rapport à l'autre des deux bandes.

11. Système selon l'une quelconque des revendications précédentes, comprenant en outre un dispositif de chauffe (52) destiné à chauffer les substrats supportés par le convoyeur de transport et/ou la ou les bandes avant d'atteindre la zone de pincement.

12. Système selon l'une quelconque des revendications précédentes, comprenant en outre un applicateur pour appliquer un adhésif sur au moins l'un des substrats et des bandes avant d'atteindre la zone de pincement ou avant le passage à travers un dispositif de chauffe, lorsqu'il est présent.

13. Système selon l'une quelconque des revendications précédentes, comprenant en outre au moins une station de post-transfert en aval de la zone de pincement, l'au moins une station de post-transfert étant éventuellement sélectionnée parmi une station de refroidissement (23) adaptée pour diminuer une température des substrats et/ou de la ou des bandes, une station de séparation adaptée pour séparer la bande d'une surface du substrat, et une station de post-traitement adaptée pour modifier les motifs de substance et/ou leur adhérence aux substrats.

14. Système selon la revendication 13, dans lequel les motifs de substance comprennent des particules de matériau électriquement conducteur et au moins une station de post-transfert est une station de post-traitement adaptée pour fritter les particules, de manière à rendre le motif électriquement conducteur.

15. Procédé d'introduction d'un substrat (10) dans une zone de pincement (40) définie entre un rouleau de pression (22 (22a ou 22b)) et une surface opposée à travers laquelle le substrat est entraîné, dans lequel procédé le substrat est avancé vers la zone de pincement (40) au moyen d'un convoyeur de transport (58) qui est configuré pour cesser d'appliquer une force au substrat lors de la mise en prise du bord d'attaque du substrat à l'intérieur de la zone de pincement, de manière à éviter que le substrat ne soit comprimé, **caractérisé en ce que** le convoyeur de transport est formé avec une saillie (66) pour mettre en prise un bord de fuite du substrat pour pousser le substrat vers la zone de pincement, et la vitesse du convoyeur de transport est réglée pour être inférieure à la vitesse de passage du substrat à travers la zone de pincement, de sorte que lors de l'entrée du bord d'attaque du substrat dans la zone de pincement, le bord de fuite se sépare de la saillie du convoyeur de transport.
